Europäisches Patentamt

European Patent Office

Office européen des brevets

(11) Veröffentlichungsnummer: **0 402 499**
**A1**

(19)

(12) **EUROPÄISCHE PATENTANMELDUNG**

(21) Anmeldenummer: 89110728.6

(51) Int. Cl.5: **G01R 31/28**

(22) Anmeldetag: **13.06.89**

(43) Veröffentlichungstag der Anmeldung:
**19.12.90 Patentblatt 90/51**

(84) Benannte Vertragsstaaten:
**DE FR GB NL**

(71) Anmelder: **Siemens Aktiengesellschaft**
**Wittelsbacherplatz 2**
**D-8000 München 2(DE)**

(72) Erfinder: **Brunner, Matthias, Dr. Ing.**
**Graf-Andechs-Strasse 30**
**D-8011 Kirchheim(DE)**
Erfinder: **Wessely, Hermann, Dipl.-Ing.**
**Paul-Hösch-Strasse 1**
**D-8000 München 60(DE)**

(54) Verfahren zur Prüfung einer Leiterplatte mit einer Teilchensonde.

(57) Zur Durchführung der Verfahren zur Prüfung der elektrischen Eigenschaften von Leiterplatten mit der Elektronensonde werden üblicherweise modifizierte Rasterelektronenmikroskope eingesetzt. Deren Abtastfeld ist aber infolge des Ablenkfarbfehlers und der mit dem Ablenkwinkel stark anwachsenden Aberrationen der Objektivlinse begrenzt. Um auch größere Leiterplatten ohne aufwendige Verbesserung der Elektronenoptik testen zu können wird vorgeschlagen, die Leiterplatte in mehrere aneinandergrenzende Bereiche zu unterteilen, wobei die Größe der Bereiche jeweils annähernd der Größe des Abtastfeldes entspricht. Jedes der nur innerhalb eines der Bereiche liegenden Netzwerke wird dann in der bekannten Weise getestet. Um Kurzschlüsse zwischen Netzwerken verschiedener Bereich sowie Unterbrechungen zwischen Kontaktpunkten bereichsübergreifender Netzwerke nachzuweisen, schließt sich dem bekannten Prüfverfahren ein weiterer Testzyklus an.

EP 0 402 499 A1

## Verfahren zur Prüfung einer Leiterplatte mit einer Teilchensonde

Die Erfindung betrifft Verfahren zur Prüfung einer Leiterplatte nach dem Oberbegriff der Patentansprüche 1 und 4.

Elektronenstrahlmeßverfahren zur Prüfung der elektrischen Eigenschaften von Leiterplattten und miniaturisierten Verbindungsmodulen sind aus Scanning Electron Microscopy (1985) III, S. 991-999, Microelectronics Engineering 8 (1988), S. 25-35 und der US-A-4 417 203 bekannt. Zur Durchführung dieser Verfahren werden üblicherweise modifizierte Rasterelektronenmikroskope eingesetzt. Deren Abtastfeld ist aber infolge des Ablenkfarbfehlers und der mit dem Ablenkwinkel stark anwachsenden Aberrationen der Objektivlinse begrenzt, so daß man gegenwärtig nur Leiterplatten mit einer maximalen Größe von etwa 10 cm x 10 cm überprüfen kann (Sondendurchmesser d ≤ 30 μm). Bestrebungen, das Abtastfeld durch Verbesserung der Elektronenoptik zu vergrößern, führten zur Entwicklung fehlerarmer Objetivlinsen mit integrierten Ablenksystemen (s. beispielsweise J. Vac. Sci. Techn., Vol. 19, No. 4, 1981, S. 1014-1018). Deren Weiterentwicklung ist allerdings mit einem hohen technischen und finanziellen Aufwand verbunden.

Der Erfindung liegt die Aufgabe zugrunde, ein Verfahren der eingangs genannten Art anzugeben, das es erlaubt, auch beliebig große Leiterplatten ohne aufwendige Verbesserung der die Teilchensonde erzeugenden Optik testen zu können. Diese Aufgabe wird erfindungsgemäß durch Verfahren nach den Patentansprüchen 1 und 4 gelöst.

Der mit der Erfindung erzielbare Vorteil besteht insbesondere darin, daß auch große Leiterplatten in Elektronenstrahlmeßgeräten mit einem relativ kleinen Abtastfeld geprüft werden können.

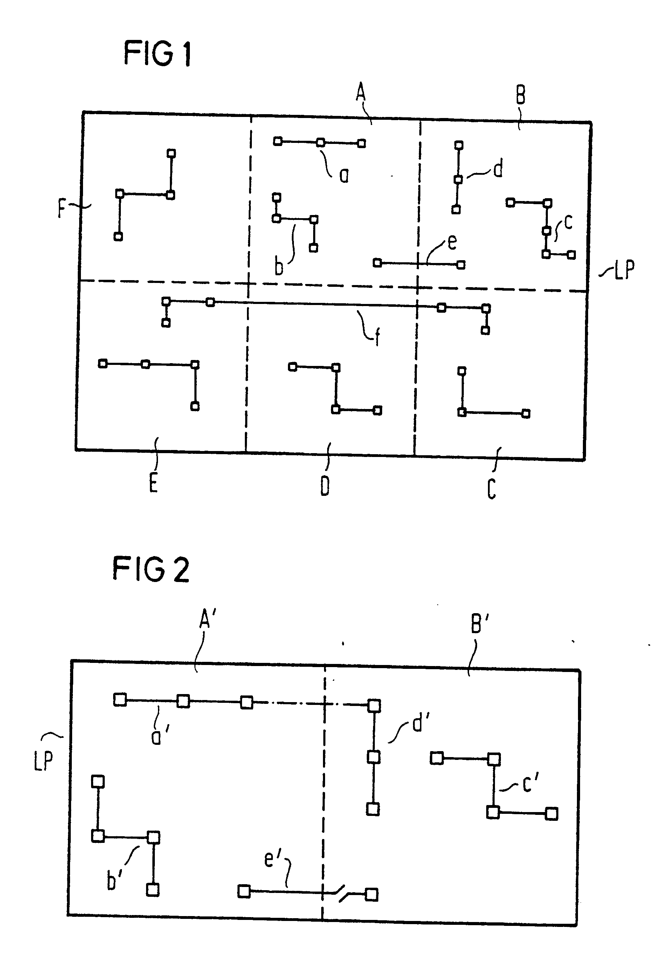

Die Unteransprüche betreffen vorteilhafte Weiterbildungen der im folgenden anhand der Zeichnung erläuterten Erfindung. Hier-bei zeigen die Fig. 1 und 2 Leiterplatten mit mehreren aus Kontaktpunken und Leiterbahnen bestehenden Netzwerken.

Die Fig. 1 zeigt eine Leiterplatte LP mit mehreren aus einer Vielzahl von Kontaktpunkten (pads) und Leiterbahnen bestehenden Netzwerken, deren elektrische Eigenschaften in einem beispielsweise aus der EP-A-0 189 777 bekannten Elektronenstrahlmeßgerät überprüft werden sollen. Da man die Elektronensonde infolge der Aberrationen der Objektivlinse und der Ablenkeinheit nur auf den in der näheren Umgebung der optischen Achse liegenden Kontaktpunkten sicher positionieren kann, unterteilt man die Leiterplatte LP in mehrere aneinandergrenzende Bereiche A bis F, deren Größe jeweils annähernd der Größe des für einen gegebenen Sondendurchmesser d ≤50 μm maximalen Abtastfelds entspricht. Zur Prüfung der Netzwerke auf Kurzschlüsse und Unterbrechungen wird einer der Bereiche (beispielsweise A) durch mechanische Verschiebung der Leiterplatte LP oder der Elektronenoptik mit dem für die Objektivlinse charakteristischen Abtastfeld zur Deckung gebracht. Anschließend lädt man einen der Kontaktpunkte eines innerhalb des Bereichs A liegenden Netzwerks (beispielsweise a) auf und überprüft, ob die zu demselben Netzwerk gehörenden anderen Kontaktpunkte ebenfalls geladen sind. Ist dies nicht der Fall, muß eine Unterbrechung vorhanden sein. Einen Kurzschluß weist man dadurch nach, daß sich mit der Aufladung des Netzwerks a auch Kontaktpunkte anderer Netzwerke (beispielsweise Kontaktpunkte des Netzwerks b) aufladen. Nach Durchführung der entsprechenden Messung an dem ebenfalls nur innerhalb des Bereichs A liegenden Netzwerke b, verschiebt man die Leiterplatte LP, um einen anderen Bereich (beispielsweise B) mit dem Abtastfeld zur Deckung zu bringen und dessen Netzwerke in der beschriebenen Weise zu testen. Entsprechendes wiederholt sich an allen übrigen Bereichen C bis F, wobei man vor Beginn des Prüfzyklus die Leiterplatte LP, beispielsweise durch Bestrahlung mit Ionen, niederenergetischen Elektronen oder Photonen, jeweils entlädt.

Die so vorgenommene Prüfung der Leiterplatte LP erlaubt es, Kurzschlüsse und Unterbrechungen in den innerhalb der einzelnen Bereiche A bis F liegenden Netzwerken nachzuweisen. Kurzschlüsse zwischen Netzwerken verschiedener Bereiche (z. B. in den Netzwerken a und d) sowie Unterbrechungen zwischen Kontaktpunkten bereichsübergreifender Netzwerke (z. B. in den Netzwerken e oder f) kann man hiermit allerdings noch nicht feststellen. Dies erfordert einen weiteren Testzyklus, bei dem man die Netzwerke eines Bereichs (beispielsweise A) jeweils in Bezug auf die aller anderen Bereiche B bis F überprüft. Zur Erläuterung dieses Testzyklus sei im folgenen angenommen, daß das Abtastfeld des verwendeten Elektronenstrahlmeßgeräts eine Unterteilung der Leiterplatte in nur zwei Bereiche A' und B' erfordert (s. Fig. 2). Hierbei sollen die Kontaktpunkte der Netzwerke a', b' und c' nur innerhalb eines der Bereiche A' oder B' liegen. Weiterhin soll in dem Netzwerk d' eine leitende Verbindung (Kurzschluß) zum Netzwerk a' bestehen (in Fig. 2 strichpunktiert dargestellt) und im Netzwerk e' eine Unterbrechung vorhanden sein.

Der Testzyklus läßt sich dann wie folgt beschreiben:
- Durchführung der Tests innerhalb der Bereiche A' und B' jeweils wie oben beschrieben.
- Entladen der Leiterplatte,

- Positionieren des Bereichs A′ im Abtastfeld des Elektronenstrahlmeßgeräts,
- Aufladen aller im Bereich A′ liegenden Kontaktpunkte,
- Positionieren des Bereichs B′ im Abtastfeld des Elektronenstrahlmeßgeräts,
- Abtasten des Ladungszustands der im Bereich B′ liegenden Kontaktpunkte mit der Elektronensonde durch Nachweis der jeweils ausgelösten Sekundärelektronen,
- Vergleich des jeweils gemessenen Ladungszustands mit dem aufgrund der Netzwerkgeometrie erwarteten Ladungszustand.

Nach Durchführung der Messung kann man somit feststellen, daß der im Bereich B′ liegende Kontaktpunkt des Netzwerks e′ nicht geladen ist. In diesem Netzwerk muß demzufolge eine Unterbrechung vorhanden sein.

Die Verbindung (Kurzschluß) des Netzwerkes d′ zum Netzwerk a′ äußert sich dadurch, daß das Netzwerk d′ geladen ist.

Entsprechende Prüfschritte sind beim Testen von Leiterplatten durchzuführen, die man aufgrund des begrenzten Abtastfeldes des Elektronenstrahlmeßgeräts in mehr als zwei Bereiche unterteilen muß. Hierbei wird die Auf- bzw. Entladung der außerhalb des Abtastfelds liegenden Kontaktpunkte vorzugsweise mit einem großflächigen Elektronen-, Ionen- oder Photonenstrahl vorgenommen, so daß man jeden Bereich nur einmal mit dem Abtastfeld zur Deckung bringen muß. Eine mechanische Verschiebung der Leiterplatte bzw. der Elektronenoptik läßt sich vermeiden, wenn man jedem der Bereiche ein Elektronenstrahlsystem zuordnet.

Gemäß weiterer Erfindung lassen sich Kurzschlüsse in Netzwerken verschiedener Bereiche sowie Unterbrechungen zwischen Kontaktpunkten bereichsübergreifender Netzwerke nach Durchführung der folgenden Verfahrensschritte nachweisen:
- Aufladen aller Kontaktpunkte der Leiterplatte,
- Entladen der im Bereich B′ liegenden Kontaktpunkte,
- Positionieren des Bereichs A′ im Abtastfeld des Elektronenstrahlmeßgeräts und
- Abtasten des Ladungszustands der im Bereich A′ liegenden Kontaktpunkte mit der Elektronensonde.

Der Vergleich des gemessenen mit dem aufgrund der Netzwerkgeometrie jeweils erwarteten Ladungszustand führt hier ebenfalls zu dem Ergebnis, daß die Netzwerke a′ und d′ leitend verbunden sind (mit der Entladung der im Bereich B′ liegenden Kontaktpunkte des Netzwerks d′ entlädt sich aufgrund des bestehenden Kurzschlusses auch das Netzwerk a′). Außerdem erkennt man am Ladungszustand des im Bereich A′ liegenden Kontaktpunkts des Netzwerks e′, daß in diesem eine Unterbrechung vorhanden sein muß.

**Ansprüche**

1. Verfahren zur Prüfung einer Leiterplatte mit einer Teilchensonde, wobei die Leiterplatte mehrere aus Kontaktpunkten und Leiterbahnen bestehende Netzwerke aufweist,
**dadurch gekennzeichnet,**

a) daß die Leiterplatte in mehrere aneinandergrenzende Bereiche unterteilt wird,

b) daß die außerhalb eines ersten Bereichs liegenden Kontaktpunkte aufgeladen werden,

c) daß der Ladungszustand der innerhalb des ersten Bereichs liegenden Kontaktpunkte mit Hilfe der Teilchensonde abgefragt wird und

d) daß der jeweils gemessene Ladungszustand mit dem aufgrund der Netzwerkgeometrie erwarteten Ladungszustand verglichen wird.

2. Verfahren nach Anspruch 1,
**dadurch gekennzeichnet,** daß die Verfahrensschritte b) bis d) für jeden der anderen Bereiche in entsprechender Weise durchgeführt werden, wobei die Leiterplatte vor Durchführung des Verfahrensschritts b) jeweils entladen wird.

3. Verfahren nach Anspruch 1,
**gekennzeichnet durch** die Abwandlung, daß nur die innerhalb eines zweiten Bereichs liegenden Kontaktpunkte aufgeladen werden.

4. Verfahren zur Prüfung einer Leiterplatte mit einer Teilchensonde, wobei die Leiterplatte mehrere aus Kontaktpunkten und Leiterbahnen bestehende Netzwerke aufweist,
**dadurch gekennzeichnet,**

a) daß die Leiterplatte in mehrere aneinandergrenzende Bereiche unterteilt wird,

b) daß alle zu prüfenden Kontaktpunkte der Leiterplatte aufgeladen werden,

c) daß die außerhalb eines ersten Bereichs liegenden Kontaktpunkte entladen werden,

d) daß der Ladungszustand der innerhalb des ersten Bereichs liegenden Kontaktpunkte mit Hilfe der Teilchensonde abgefragt wird und

e) daß der jeweils gemessene Ladungszustand mit dem aufgrund der Netzwerkgeometrie erwarteten Ladungszustand verglichen wird.

5. Verfahren nach Anspruch 4,
**dadurch gekennzeichnet,** daß die Verfahrensschritte b) bis e) für jeden der anderen Bereiche in entsprechender Weise durchgeführt werden.

6. Verfahren nach einem der Ansprüche 1 bis 5,
**dadurch gekennzeichnet,** daß die Größe der Bereiche jeweils annähernd der Größe des Abtastbereichs der Teilchensonde entspricht.

7. Verfahren nach einem der Ansprüche 1 bis 6,
**dadurch gekennzeichnet,** daß die Kontaktpunkte mit der Teilchensonde aufgeladen werden.

8. Verfahren nach einem der Ansprüche 1 bis 6.
**dadurch gekennzeichnet,** daß die Kontaktpunkte durch eine flächenhafte Bestrahlung der jeweiligen Bereiche mit einem Korpuskularstrahl aufgeladen oder entladen werden.

9. Verfahren nach Anspruch 6,
**dadurch gekennzeichnet,** daß die Bereiche durch Verschiebung der Leiterplatte oder einer die Teilchsonde erzeugenden Teilchenoptik mit dem Abtastbereich zur Deckung gebracht wird.

## FIG 1

## FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | EP-A-0 266 535 (IBM) <br> * Spalte 6, Zeilen 39-53; Spalte 8, Zeilen 10-33; Figur 2 * <br> --- | 1,7-8 | G 01 R 31/28 |
| A | US-A-4 733 174 (CROSBY) <br> * Spalte 5, Zeile 29 - Spalte 8, Zeile 34; Figuren 1-2,5 * <br> --- | 1-2,4-5 | |
| A | MICROELECTRONIC ENGINEERING, Band 4, Nr. 2, Dezember 1986, Seiten 139-157; F.J. HOHN: "Background and applications of electron beam test techniques" <br> * Seite 147, Zeile 35 - Seite 150, Zeile 15; Seite 152, Zeile 8 - Seite 154, Zeile 19; Figuren 5-7,11-13 * <br> --- | 4,7-8 | |
| D,A | EP-A-0 066 070 (IBM) <br> * Seite 10, Zeilen 4-18; Seite 14, Zeilen 5-27; Seite 16, Zeilen 8-24; Figuren 1-4 * <br> ----- | 1,4-5 | |
| | | | **RECHERCHIERTE SACHGEBIETE (Int. Cl.5)** <br><br> G 01 R 31/00 |

Der vorliegende Recherchenbericht wurde für alle Patentansprüche erstellt

| Recherchenort | Abschlußdatum der Recherche | Prüfer |
|---|---|---|
| DEN HAAG | 03-03-1990 | TRELEVEN C. |